# EUROPEAN PATENT APPLICATION

(11) **EP 1 643 582 A1**
(43) Date of publication of application: **05.04.2006**
(21) Application number: 05020163.1
(22) Date of filing: 15.09.2005
(51) Int. Cl.: H01M 10/04, H01M 2/02, H05K 1/18

(54) **Method of fabricating rechargeable batteries**

(30) Priority: 29.09.2004 CN 200410080627
(71) Applicant: Antig Technology Co., Ltd., 114 Taipei (TW)
(72) Inventor: Chen, Cheng-Hsin, Tapei, Taiwan (TW); Shen, Ko-Chen, Taipei, Taiwan (TW); Shu, His-Ming, Hsin Chuang City, Taipei County, Taiwan (TW)
(74) Representative: Viering, Jentschura & Partner

(57) **Abstract**

A method of fabricating a rechargeable battery is described. The method comprises of (A) laminating an anode slurry and a cathode slurry separately on an upper surface and a lower surface of a substrate having two-sided metallic laminae, so as to construct a dual-collector electrode; (B) forming a package component using a printed circuit substrate; and (C) using the package component to compact an electrolyte and at least a core component of a secondary cell into an inner space of the package component, wherein the core component comprises the dual-collector electrode.

## Description

### FIELD OF THE INVENTION

The present invention relates to a method of fabricating a secondary battery, and more particularly, to a method of utilizing printed circuit substrates and printed circuit board (PCB) processes to manufacture a rechargeable battery.

### BACKGROUND OF THE INVENTION

The structure of conventional rechargeable batteries, such as lithium ion batteries, nickel metal hydride batteries and lithium polymer batteries include core cells, which are usually fabricated by battery manufactures and covered with metallic material as package shells in advance. Then, the metallic-shelled core cells are delivered to assembling factories that will electrically connect the core cells to protective circuits. Finally, the protective circuits and the core cells are packed with outer casings of a material other than metal, for example, plastic outer casings, such that rechargeable battery packs are assembled completely.

Since the aforementioned method utilizes metallic package shells, the resultant rechargeable battery occupies a large amount of space. It is thus difficult to reduce and minimize the size of the rechargeable battery.

Therefore, an improved method is needed to fabricate minimized rechargeable batteries.

### SUMMARY OF THE INVENTION

It is a primary objective of the invention to provide a method of fabricating rechargeable batteries, by which minimized secondary cells are manufactured.

It is a secondary objective of the invention to provide a method of utilizing a dual-collector electrode and a package component made from a printed circuit substrate to manufacture a rechargeable battery.

In accordance with the aforementioned objectives of the invention, a method of fabricating a rechargeable battery is disclosed. The method comprises (A) laminating an anode slurry and a cathode slurry separately on an upper surface and a lower surface of a substrate having two-sided metallic laminae, so as to construct a dual-collector electrode; (B) forming a package component using a printed circuit substrate; and (C) using the package component to compact an electrolyte and at least a core component of a secondary cell into an inner space of the package component, wherein the core component comprises the dual-collector electrode.

### BRIEF DESCRIPTION OF THE DRAWINGS

The foregoing aspects, as well as many of the attendant advantages and features of this invention, will become more apparent by reference to the following detailed description, when taken in conjunction with the accompanying drawings, wherein:
Fig. 1 illustrates a flowchart of fabricating rechargeable batteries according to one preferred embodiment of the present invention;
Fig. 2A illustrates the upper structure of the dual-collector electrode according to one embodiment of the present invention;
Fig. 2B illustrates the lower structure of the dual-collector electrode according to one embodiment of the present invention;
Fig. 3A illustrates the upper structure of the dual-collector electrode according to another embodiment of the present invention;
Fig. 3B illustrates the lower structure of the dual-collector electrode according to another embodiment of the present invention;
Fig. 4 illustrates the structure of a secondary battery fabricated by the method of the present invention;
Fig. 5A illustrates the structure of a core component of a secondary battery according to one embodiment of the present invention;
Fig. 5B shows a stacked structure of plurality of core components in Fig. 5A;
Fig. 6A illustrates the structure of a core component of a secondary battery according to another embodiment of the present invention;
Fig. 6B shows a stacked structure of plurality of core components in Fig. 6A;
Fig. 7 is a schematic diagram of a package component according to one embodiment of the invention;
Fig. 8 illustrates a detailed flowchart of sealing according to one embodiment of the invention;
Fig. 9 illustrates a cross-sectional view of a rechargeable battery according to one embodiment of the invention;
Fig. 10 illustrates a flowchart of deploying a circuit control board according to one embodiment of the invention; and
Fig. 11 shows the structure combining the secondary battery in Fig. 4 and the circuit control board.

### DETAILED DESCRIPTION OF THE INVENTION

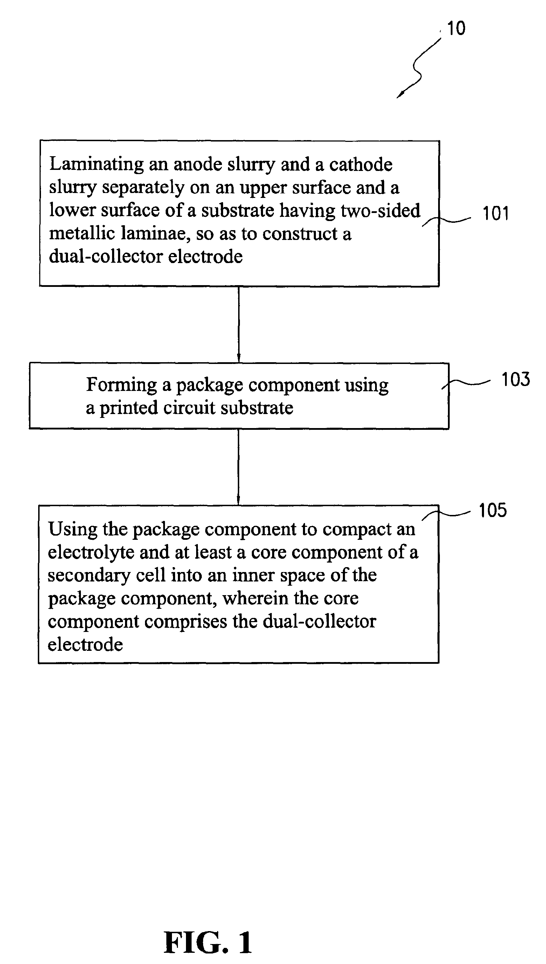

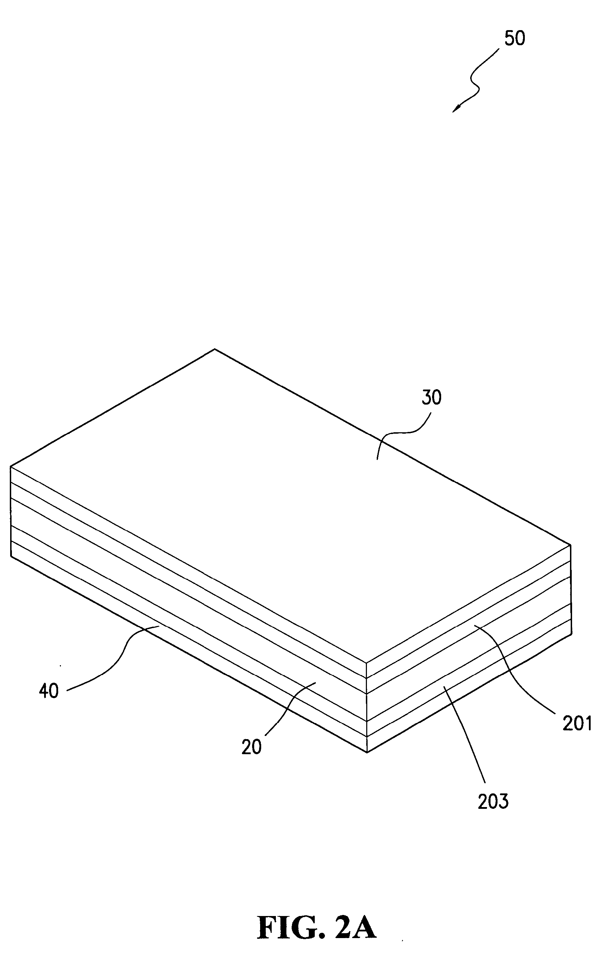

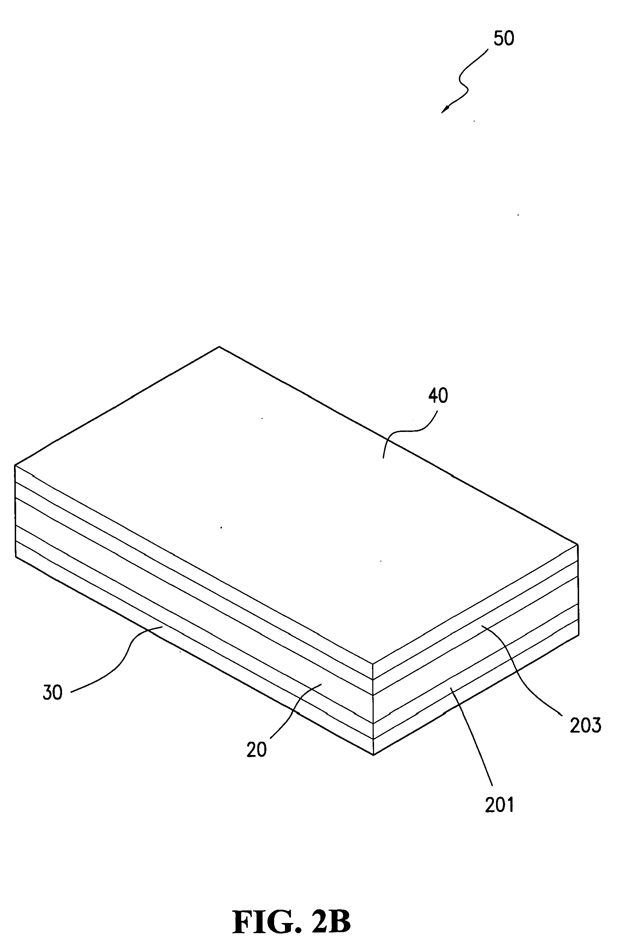

Fig. 1 shows a flowchart of fabricating rechargeable batteries according to one embodiment of the present invention. The manufacturing method 10 comprises steps 101, 103 and 105, which are separately illustrated as follows. In step 101, a substrate 20 with two-sided metallic laminae 201 and 203 is provided. Anode slurry 30 and cathode slurry 40 are formed as laminar structures on the upper surface and the lower surface of the substrate 20, respectively, so as to construct a dual-collector electrode 50. A rechargeable lithium ion battery fabricated by manufacturing method 10 is disclosed herein for clarifying the invention, which is only an exemplar and is not intended to limit the present invention. The substrate 20 is, for example, a printed circuit board (PCB) with two-sided metallic foil, e.g. copper foil 201 covering the upper surface of the substrate 20 and aluminum foil 203 covering the lower surface of the substrate 20. The anode slurry 30 is, for example, lithium cobalt oxide including active substances, and the cathode slurry 40 is, for example, carbon including active substances. Also referring to Fig. 2A and Fig. 2B, the dual-collector electrode 50 is fabricated after step 101 is finished. The copper foil 201 on the upper surface of the dual-collector electrode 50 is covered by the laminated anode slurry 30. Similarly, the aluminum foil 203 on the lower surface of the dual-collector electrode 50 is covered by the laminated cathode slurry 40. The thickness of the laminated anode slurry 30 and the cathode slurry 40 for the dual-collector electrode 50 ranges between 0.05 millimeters (mm) and 0.1 mm. The method of forming the laminar structures is performed by, for example, roll coating, coating printing, stenciling printing, steel plate printing, injecting coating, and so forth.

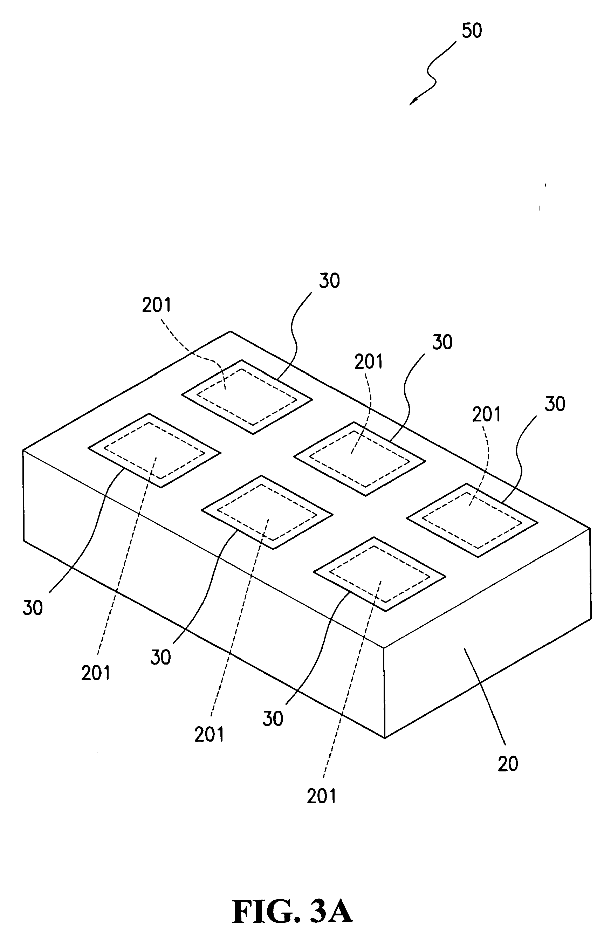

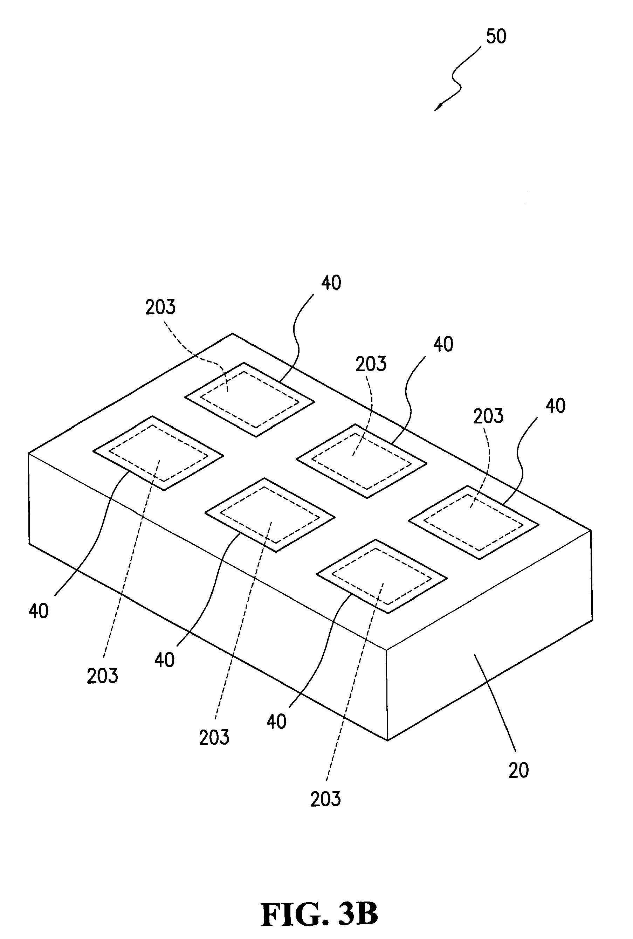

Furthermore, the dual-collector electrode 50 may be fabricated as the structure of Fig. 3A and Fig. 3B in accordance with another embodiment of the invention. As shown in Fig. 3A and Fig. 3B, the upper surface of the substrate 20 has a plurality of isolated first metallic lamina regions 201; likewise the lower surface of the substrate 20 has a plurality of isolated second metallic lamina regions 203. The anode slurry 30 is laminated only on the first metallic lamina regions 201, and the cathode slurry 40 is laminated merely on the second metallic lamina regions 203. The first metallic lamina regions 201 may be made of copper foil while the second metallic lamina regions 203 may be made from aluminum foil.

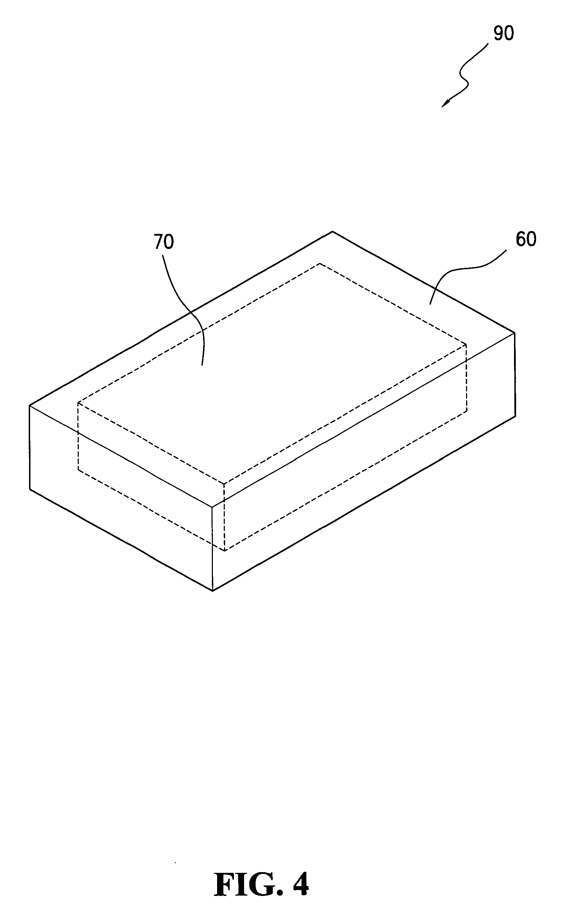

Step 103 is performed to manufacture a package component 60 using printed circuit substrates. Step 105 is performed to seal electrolyte 80 and at least one core component 70 of a secondary cell inside the package component 60, wherein the core component 70 comprises the dual-collector electrode 50. Referring to Fig. 4, the inner of the package component 60 has a compartment for containing the electrolyte 80 and the core component 70 of the secondary cell. Because printed circuit substrates are used to make the package component 60, it is possible to fabricate the package component 60 and to implement the step 105 of sealing using PCB processes.

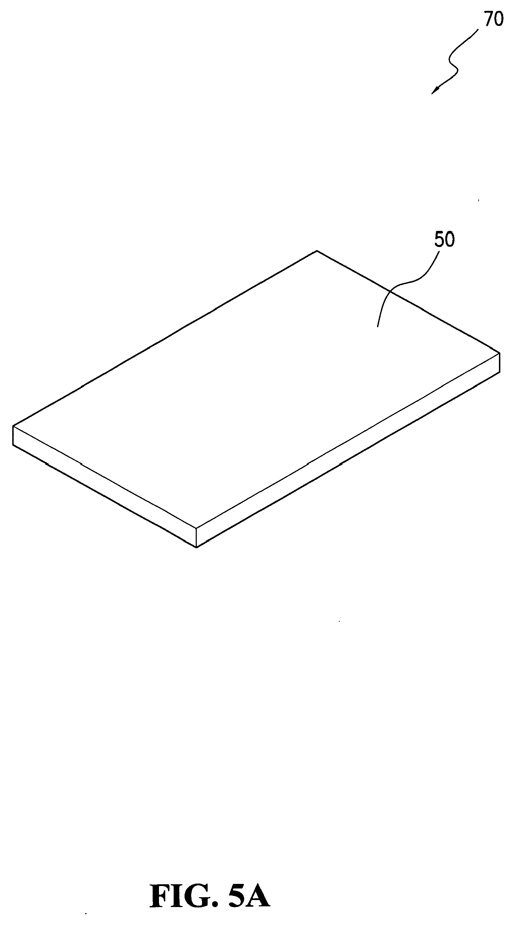

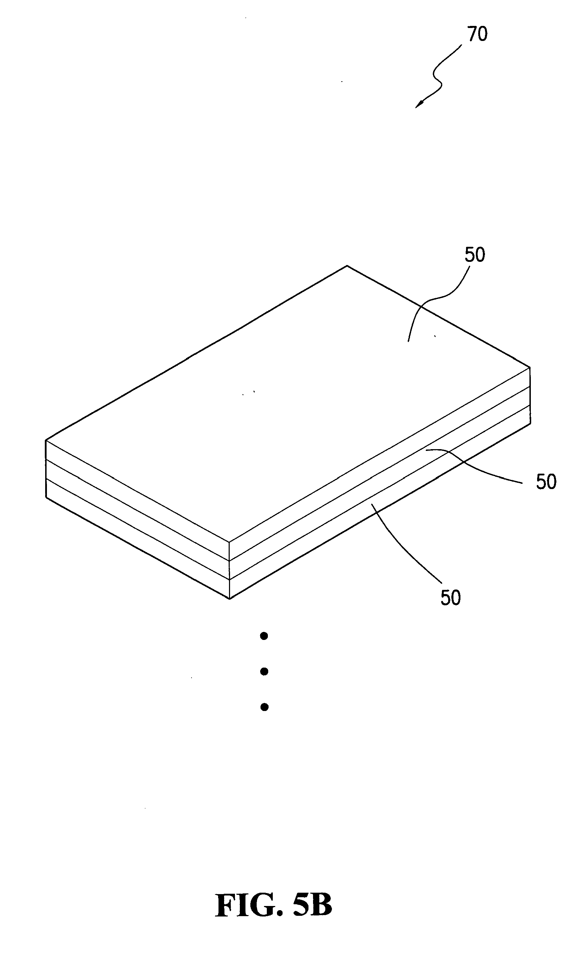

Fig. 5A shows the structure of a core component of a secondary cell. Fig. 5B shows a stacked structure of plurality of core components in Fig. 5A. Single core component 70 can be disposed inside the package component 60 as illustrated in Fig. 5A. Also, plural core components 70 stacked as Fig. 5B can be arranged within the package component 60.

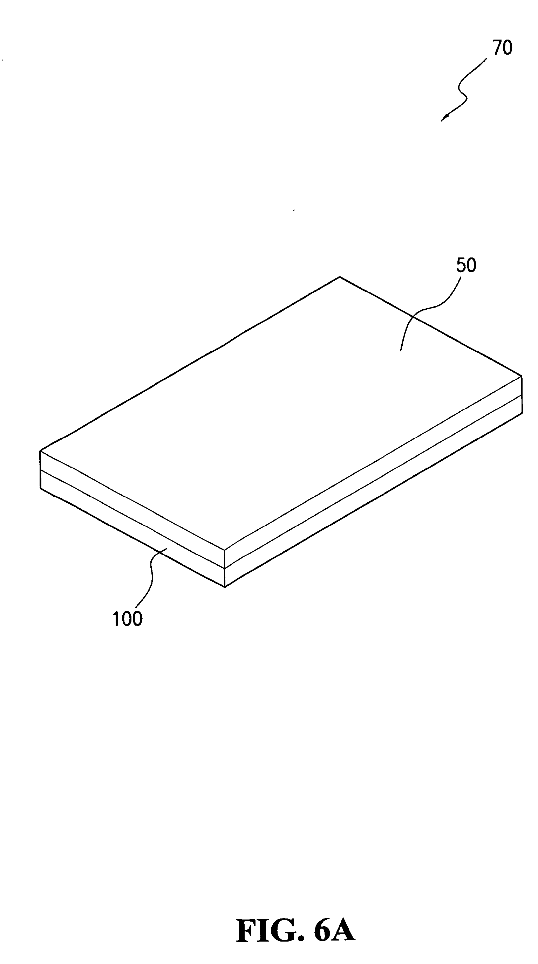

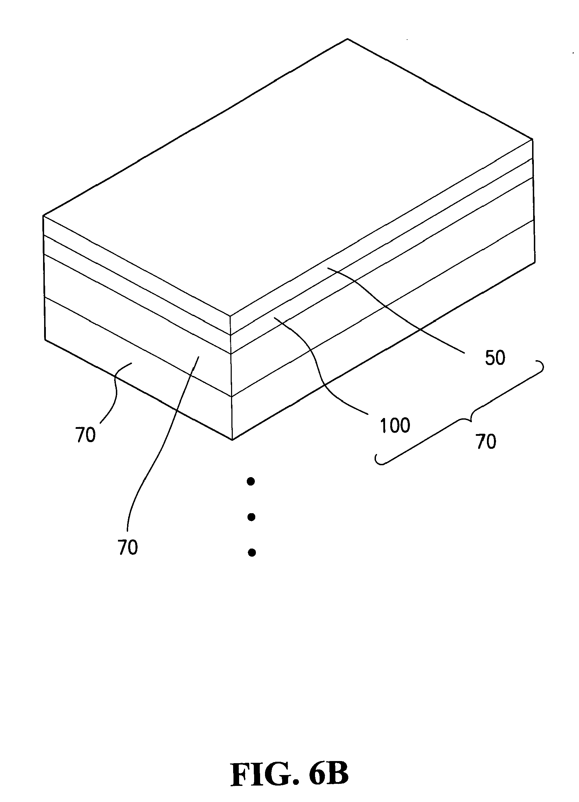

Fig. 6A shows the structure of a secondary cell's core component according to another embodiment of the present invention. Fig. 6B shows a stacked structure of a plurality of core components in Fig. 6A. The core component 70 of Figs. 6A and 6B further comprises a separating membrane 100 sandwiched in between two dual-collector electrodes 50. Additionally, plural core components 70 stacked as Fig. 6B can be disposed inside the package component 60.

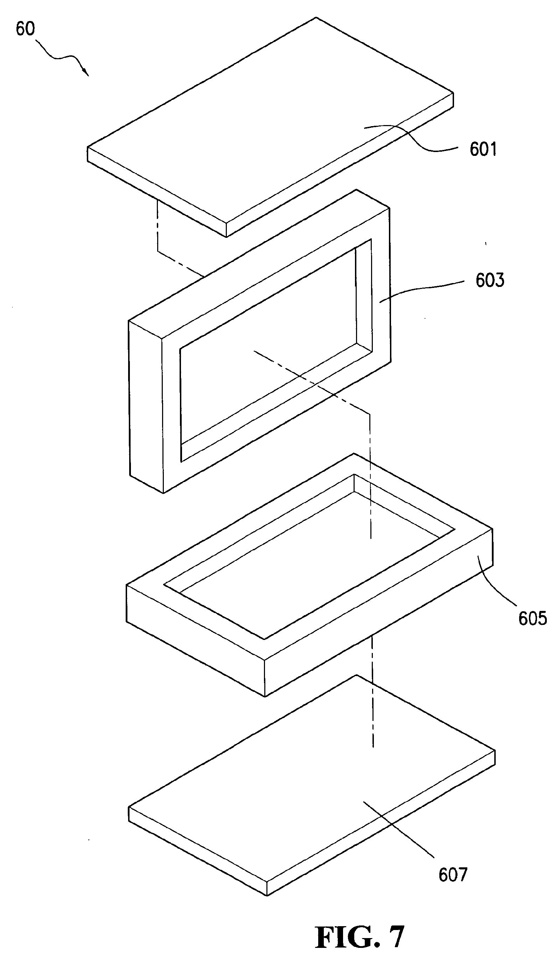

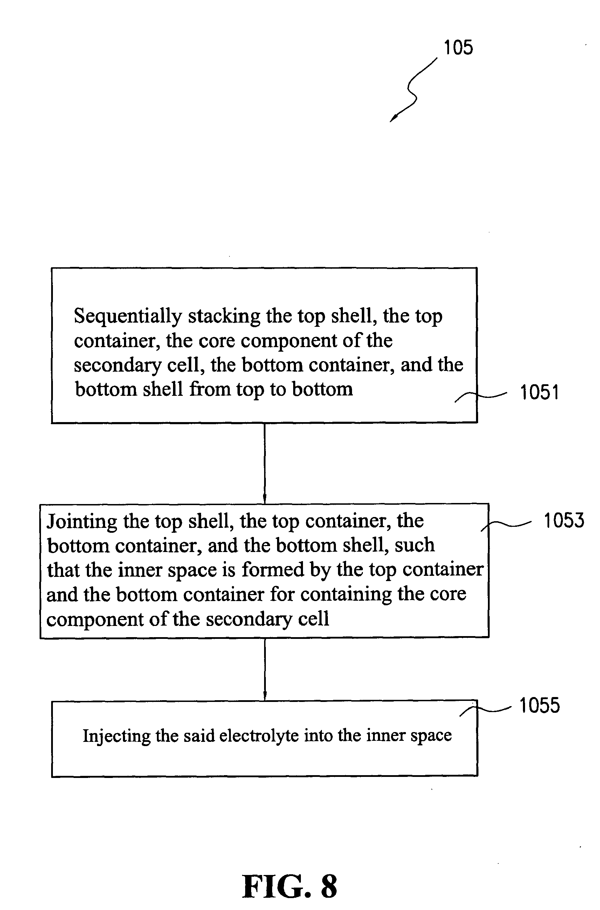

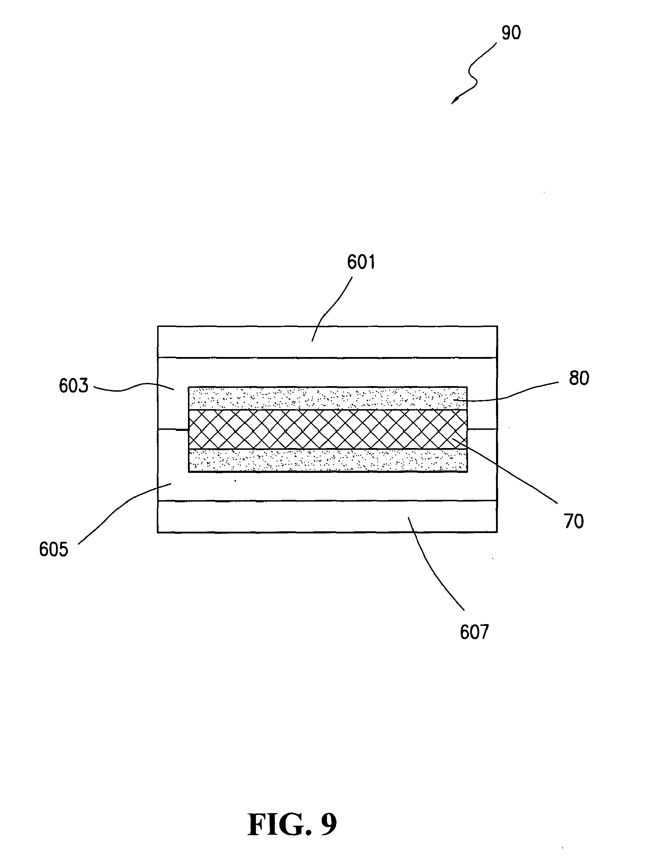

Fig. 7 is a schematic diagram of a package component according to one embodiment of the invention. The package component 60 made from printed circuit substrates in step 103 includes a top shell 601, a top container 603, a bottom container 605, and a bottom shell 607. Fig. 8 shows that the step 105 of sealing further comprises steps 1051, 1053 and 1055. In step 1051, the top shell 601, the top container 603, at least a core component 70 of a secondary cell, the bottom container 605, and the bottom shell 607 are stacked sequentially from top to bottom. Step 1053 is performed to joint the top shell 601, the top container 603, the bottom container 605, and the bottom shell 607, such that a compartment is formed by the top container 603 and the bottom container 605 for containing the core component 70. The electrolyte 80 is injected into the inner space of the compartment in step 1055. Step 1053 of jointing is carried out, for example, by means of a thermo-compressor with a pressure of 18-30 Kg/cm2 at an ambient temperature of 70-100□, so as to compress the top shell 601, the top container 603, the bottom container 605, and the bottom shell 607 into a compact structure. In step 1055, the electrolyte 80 is injected into the inner space by, for instance, diffusing due to pressure drop, or filling at vacuum. The amount of the electrolyte 80 after step 1055 is approximately 5%-10% of total weight of a rechargeable battery 90 as illustrated in Fig. 9, which is a cross-sectional view of the rechargeable battery 90 after steps 1051 and 1053 are performed.

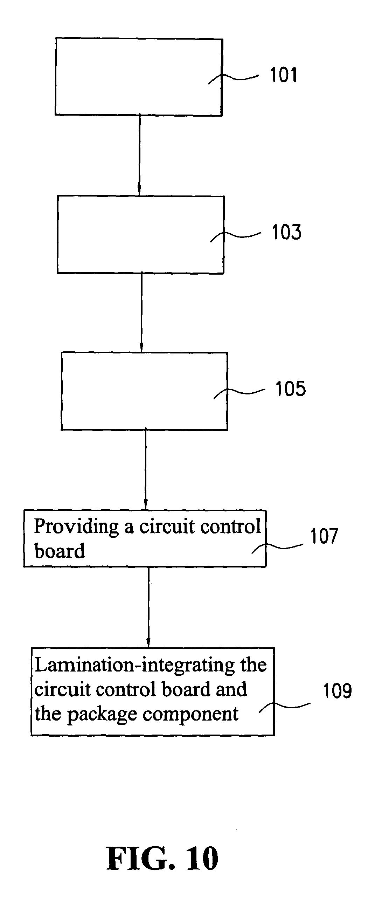

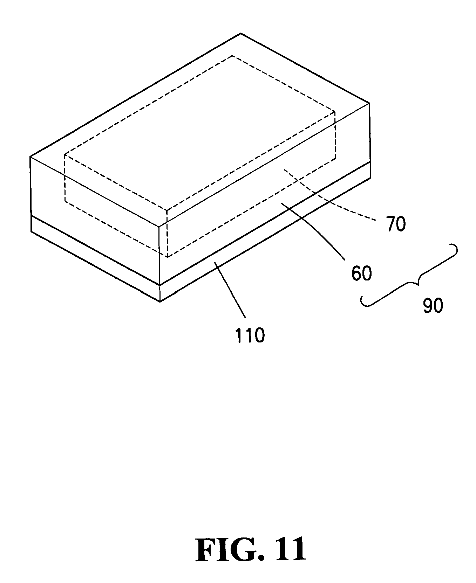

Fig. 10 is a flowchart of deploying a circuit control board, showing that the manufacturing method 10 further comprises steps 107, 109 after steps 101-105. A circuit control board 110 is provided in step 107. The circuit control board 110 includes at least one circuit composed of electronic devices (not shown) and electrically connected to the core component 80. Step 109 is performed to laminate-integrate the circuit control board 110 and the package component 60. As illustrated in Fig. 11, the lateral bottom of the package component 60 of the rechargeable battery 90 is physically connected to the circuit control board 110. The circuit control board 110, of course, can be connected to the lateral top of the package component 60 instead.

The electrolyte 80 may be solid electrolyte, liquid electrolyte or gel electrolyte. Moreover, the rechargeable battery 90 fabricated by manufacturing method 10 is operated in battery activation and learning life cycle testing processes, which are known to those skilled in the art and will not be described in detail. During the battery activation process, the rechargeable battery 90 is charged to a maximum voltage, i.e. 4.2V, by applying constant current, and then continuously charged with the maximum voltage until current is less than 0.01C. Next, the rechargeable battery 90 is discharged at constant current to a minimum discharge voltage, for instance, 2.75V. Repeat the aforesaid procedures two times or more. Finally, the rechargeable battery 90 is put 10 to 15 days. On the other hand, learning life cycle testing process may be executed by sampling. A sample rechargeable battery 90 is discharged based on standard discharge procedure and is placed for 15 minutes after being completely discharged. Test (A) and test (B) then proceed. For test (A), the sample rechargeable battery 90 is charged according to standard rapid charge procedure in an environment of 20±5□ and 65±5%RH, and is placed for 15 minutes after completely charged. For test (B), the sample rechargeable battery 90 is discharged with a current of 1500mA until the voltage thereof reaches the minimum discharge voltage. The cycling of test (A) and test (B) is repeated until the discharge capacity of the sample rechargeable battery 90 is less than 60% of minimal capacity thereof. The number of cycling represents the shelf life of the rechargeable battery 90.

While the invention has been particularly shown and described with reference to the preferred embodiments thereof, these are, of course, merely examples to help clarify the invention and are not intended to limit the invention. It will be understood by those skilled in the art that various changes, modifications, and alterations in form and details may be made therein without departing from the spirit and scope of the invention, as set forth in the following claims.

## Claims

1. A method of fabricating a rechargeable battery, comprising the steps of:
(A). laminating an anode slurry and a cathode slurry separately on an upper surface and a lower surface of a substrate having two-sided metallic laminae, so as to construct a dual-collector electrode;
(B). forming a package component using a printed circuit substrate; and
(C). using said package component to compact an electrolyte and at least a core component of a secondary cell into an inner space of said package component,
wherein said core component comprises said dual-collector electrode.

2. The method of claim 1, wherein the step (B) comprises:
forming a top shell, a top container, a bottom container, and a bottom shell using said
printed circuit substrate, wherein said package component comprises said top shell,
said top container, said bottom container, and said bottom shell.

3. The method of claim 2, wherein the step (C) comprises:
(c1). sequentially stacking said top shell, said top container, said core component of the secondary cell, said bottom container, and said bottom shell from top to bottom;
(c2). jointing said top shell, said top container, said bottom container, and said bottom shell, such that the inner space is formed by said top container and said bottom container for containing said core component of the secondary cell; and
(c3). injecting the said electrolyte into the inner space.

4. The method of claim 3, wherein the step (c2) comprises using a printed circuit board process.

5. The method of claim 1, further comprising the steps of:
(E). providing a circuit control board; and
(F). lamination-integrating said circuit control board and said package component.

6. The method of claim 1, wherein said core component of the secondary cell further comprises a separating membrane.

7. The method of claim 1, wherein said electrolyte is a solid electrolyte, a liquid electrolyte, or a gel electrolyte.

8. The method of claim 1, wherein the said anode slurry is comprised of lithium cobalt oxide.

9. The method of claim 1, wherein the said cathode slurry is comprised of carbon.

10. The method of claim 1, wherein the metallic lamina on the upper surface of the said substrate is comprised of copper foil.

11. The method of claim 1, wherein the metallic lamina on the lower surface of the said substrate is comprised of aluminum foil.

12. The method of claim 1, wherein the step (A) comprises:
(a1). providing said substrate having the upper surface covered by a first metallic lamina and the lower surface covered by a second metallic lamina;
(a2). laminating said anode slurry on said first metallic lamina; and
(a3). laminating said cathode slurry on said second metallic lamina.

13. The method of claim 12, wherein said first metallic lamina comprises copper foil, and said second metallic lamina comprises aluminum foil.

14. The method of claim 1, wherein the step (A) comprises:
(a1). providing said substrate having a plurality of isolated first metallic lamina regions on the upper surface and a plurality of isolated second metallic lamina regions on the lower surface;
(a2). laminating said anode slurry on each of the isolated first metallic lamina regions; and
(a3). laminating said cathode slurry on each of the isolated second metallic lamina regions.

15. The method of claim 14, wherein said isolated first metallic lamina regions comprise copper foil, and said isolated second metallic lamina regions are comprised of aluminum foil.
